# EUROPEAN PATENT APPLICATION

(11) **EP 3 787 021 A1**
(43) Date of publication of application: **03.03.2021**
(21) Application number: 18899004.8
(22) Date of filing: 21.11.2018
(51) Int. Cl.: H01L 23/528, H01L 21/77, H01L 27/12

(54) **ARRAY SUBSTRATE AND PREPARATION METHOD THEREFOR, AND DISPLAY DEVICE**

(30) Priority: 17.04.2018 CN 201810344260
(71) Applicant: BOE TECHNOLOGY GROUP CO., LTD., Beijing 100015 (CN)
(72) Inventor: The designation of the inventor has not yet been filed
(74) Representative: Klunker IP Patentanwälte PartG mbB
(86) International application number: PCT/CN2018/116771
(87) International publication number: WO 2019/200912

(57) **Abstract**

An array substrate (100) and a manufacturing method thereof and a display device are provided. The array substrate (100) includes: a base substrate (101); a first conductive pattern (102) on the base substrate (101); an insulating layer (103) on a side of the first conductive pattern (102) away from the base substrate (101), a via hole structure (1031) being in the insulating layer (103); a second conductive pattern (105) which is on a side of the insulating layer (103) away from the base substrate (101) and is electrically connected with the first conductive pattern (102) at the via hole structure (1031); and a protective pattern (106) on a side of a connection electrode (104) away from the base substrate (101). An orthographic projection of the protective pattern (106) on the base substrate (101) at least partially overlap an orthographic projection of the via hole structure (1031) on the base substrate (101). The protective pattern (106) prevents the first conductive pattern (102) below the via hole structure (1031) from being corroded or the like.

## Description

This application claims the benefit of Chinese patent application No. 201810344260.9 filed on April 17, 2018, which is hereby entirely incorporated by reference as a part of the present application.

### TECHNICAL FIELD

Embodiments of the present disclosure relate to an array substrate, a manufacturing method of the array substrate and a display device.

### BACKGROUND

At present, an array substrate included in a display panel such as a liquid crystal display panel or an organic light-emitting display panel or the like is formed by a plurality of patterning processes. For example, a thin film transistor having a switching function is formed in a display region of the display panel by the patterning processes, and a leading wire connecting a display region functional element and a peripheral region driving circuit is formed in a peripheral region of the display panel. Adding of one functional layer may cause one patterning process to be added in a manufacturing process, and thus complicate the manufacturing process of the array substrate.

### SUMMARY

At least one embodiment of the present disclosure provides an array substrate and the array substrate includes: a base substrate; a first conductive pattern on the base substrate; an insulating layer which is on a side of the first conductive pattern away from the base substrate and is provided with a via hole structure therein; a second conductive pattern which is on a side of the insulating layer away from the base substrate and is electrically connected with the first conductive pattern at the via hole structure; a protective pattern on the side of the first conductive pattern away from the base substrate. An orthographic projection of the protective pattern on the base substrate at least partially overlaps an orthographic projection of the via hole structure on the base substrate.

For example, in the array substrate provided by at least one embodiment of the present disclosure, the protective pattern is a photoresist pattern.

For example, in the array substrate provided by at least one embodiment of the present disclosure, an upper surface of the second conductive pattern and an upper surface of the protective pattern are coplanar with each other.

For example, the array substrate provided by at least one embodiment of the present disclosure further includes the connection electrode, and the connection electrode is in the via hole structure of the insulating layer and is electrically connected with the second conductive pattern and the first conductive pattern.

For example, in the array substrate provided by at least one embodiment of the present disclosure, the protective pattern is between the connection electrode and the first conductive pattern.

For example, in the array substrate provided by at least one embodiment of the present disclosure, an upper surface of the protective pattern and an upper surface of the connection electrode are coplanar with each other.

For example, in the array substrate provided by at least one embodiment of the present disclosure, an upper surface of the second conductive pattern, the upper surface of the connection electrode and the upper surface of the protective pattern are coplanar with each other.

For example, in the array substrate provided by at least one embodiment of the present disclosure, the second conductive pattern and the connection electrode are integral with each other.

For example, in the array substrate provided by at least one embodiment of the present disclosure, the array substrate includes a display region and a peripheral region; the first conductive pattern, the insulating layer, the second conductive pattern, the connection electrode and the protective pattern are at least in the peripheral region.

For example, in the array substrate provided by at least one embodiment of the present disclosure, the peripheral region further includes a flexible circuit board or an integrated circuit board; the second conductive pattern is electrically connected with the flexible circuit board or the integrated circuit board.

For example, in the array substrate provided by at least one embodiment of the present disclosure, the display region includes a driving electrode configured for driving a pixel unit in the display region to emit light; the driving electrode and the connection electrode are in a same layer.

At least one embodiment of the present disclosure further provides a manufacturing method of the array substrate, and the manufacturing method includes: providing a base substrate; forming a first conductive pattern on the base substrate; forming an insulating film on a side of the first conductive pattern away from the base substrate, and treating the insulating film to form an insulating layer and a via hole structure in the insulating layer; forming a second conductive pattern on a side of the insulating layer away from the base substrate, so that the second conductive pattern is electrically connected with the first conductive pattern at the via hole structure; and forming a protective pattern on the side of the first conductive pattern away from the base substrate, so that an orthographic projection of the protective pattern on the base substrate at least partially overlaps an orthographic projection of the via hole structure on the base substrate.

For example, in the manufacturing method of the array substrate according to at least one embodiment of the present disclosure, after the insulating film is treated to form the insulating layer and the via hole structure in the insulating layer, a conductive layer, a protective layer and a first photoresist layer are sequentially formed on the insulating layer; the first photoresist layer is exposed by using a two-tone mask and is developed to form a first photoresist pattern, and the first photoresist pattern includes a first photoresist full-retention region, a first photoresist partial-retention region and a first photoresist removal region; a region where the first photoresist full-retention region is located is a region where the protective pattern is to be formed, a region where the first photoresist removal region is located is a region where the protective pattern and the second conductive pattern are not formed, and a region where the first photoresist partial-retention region is located is a region except the first photoresist full-retention region and the first photoresist removal region; the protective layer and the conductive layer which are in the first photoresist removal region are removed to form the second conductive pattern; the first photoresist pattern is ashed to retain the first photoresist layer only in the first photoresist full-retention region; the protective layer outside the first photoresist full-retention region is removed to form the protective pattern; and the first photoresist layer in the first photoresist full-retention region is removed.

For example, the manufacturing method of the array substrate provided by at least one embodiment of the present disclosure further includes forming a connection electrode, so that the connection electrode is formed in the via hole structure to electrically connect the second conductive pattern and the first conductive pattern.

For example, in the manufacturing method of the array substrate according to at least one embodiment of the present disclosure, after the insulating film is treated to form the insulating layer and the via hole structure in the insulating layer, a conductive layer, a protective layer and a first photoresist layer are sequentially formed on the insulating layer; the first photoresist layer is exposed by using a two-tone mask and is developed to form a first photoresist pattern, and the first photoresist pattern includes a first photoresist full-retention region, a first photoresist partial-retention region and a first photoresist removal region; a region where the first photoresist full-retention region is located is a region where the protective pattern is to be formed, a region where the first photoresist removal region is located is a region where the protective pattern, the connection electrode and the second conductive pattern are not formed, and a region where the first photoresist partial-retention region is located is a region except the first photoresist full-retention region and the first photoresist removal region; the protective layer and the conductive layer which are in the first photoresist removal region are removed to form the second conductive pattern and the connection electrode electrically connected with the second conductive pattern; the first photoresist pattern is ashed to retain the first photoresist layer only in the first photoresist full-retention region; the protective layer outside the first photoresist full-retention region is removed to form the protective pattern; and the first photoresist layer in the first photoresist full-retention region is removed.

For example, in the manufacturing method of the array substrate provided by at least one embodiment of the present disclosure, the protective pattern is formed of a photoresist.

For example, in the manufacturing method of the array substrate according to at least one embodiment of the present disclosure, after the second conductive pattern is formed, a conductive layer and a second photoresist layer are sequentially formed on the base substrate; the second photoresist layer is exposed by using a single-tone mask and is developed to form a second photoresist pattern, and the conductive layer is patterned by using the second photoresist pattern to form the connection electrode; and the second photoresist pattern is ashed to form the protective pattern.

For example, in the manufacturing method of the array substrate provided by at least one embodiment of the present disclosure, after the insulating film is treated to form the insulating layer and the via hole structure in the insulating layer, a conductive layer and a third photoresist layer are sequentially formed on the base substrate; the third photoresist layer is exposed by using a two-tone mask and is developed to form a third photoresist pattern, and the third photoresist pattern includes a third photoresist full-retention region, a third photoresist partial-retention region and a third photoresist removal region; a region where the third photoresist full-retention region is located is a region where the protective pattern is to be formed, a region where the third photoresist removal region is located is a region where the protective pattern, the connection electrode and the second conductive pattern are not formed, and a region where the third photoresist partial-retention region is located is a region except the third photoresist full-retention region and the third photoresist removal region; the conductive layer in the third photoresist removal region is removed to form the second conductive pattern and the connection electrode electrically connected with the second conductive pattern; and the third photoresist pattern is ashed to retain the third photoresist layer only in the third photoresist full-retention region to form the protective pattern.

For example, in the manufacturing method of the array substrate provided by at least one embodiment of the present disclosure, after the insulating film is treated to form the insulating layer and the via hole structure in the insulating layer, the protective pattern is formed in the via hole structure; a conductive layer and a fourth photoresist layer are formed on a side of the protective pattern away from the base substrate; the fourth photoresist layer is exposed by using a single-tone mask and is developed to form a fourth photoresist pattern, and the conductive layer is patterned by using the fourth photoresist pattern to form the second conductive pattern.

For example, in the manufacturing method of the array substrate according to at least one embodiment of the present disclosure, the array substrate includes a display region and a peripheral region; the first conductive pattern, the insulating layer, the second conductive pattern, the connection electrode and the protective pattern are formed at least in the peripheral region.

For example, in the manufacturing method of the array substrate according to at least one embodiment of the present disclosure, the peripheral region further includes a flexible circuit board or an integrated circuit board; the second conductive pattern is formed to electrically connect the flexible circuit board or the integrated circuit board.

For example, in the manufacturing method of the array substrate according to at least one embodiment of the present disclosure, a driving electrode configured for driving a pixel unit in the display region to emit light is formed in the display region; the driving electrode and the connection electrode are formed by using a same film and by a same patterning process.

For example, in the manufacturing method of the array substrate according to at least one embodiment of the present disclosure, a thin film transistor is formed in the display region, and the thin film transistor includes a gate electrode, a source electrode and a drain electrode; the first conductive pattern is formed by a same film integrally with the gate electrode, the source electrode or the drain electrode.

At least one embodiment of the present disclosure also provides a display device including the array substrates described in any one of the above embodiments.

In the array substrate provided by at least one embodiment of the present disclosure, the protective pattern included in the array substrate avoids undesirable phenomena such as corrosion generated in the first conductive pattern located below the via hole structure of the insulating layer.

### BRIEF DESCRIPTION OF THE DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.
FIG. 1 is a first schematic view of an array substrate according to the embodiments of the present disclosure;
FIG. 2 is a second schematic view of the array substrate according to the embodiments of the present disclosure;
FIG. 3 is a third schematic view of the array substrate according to the embodiments of the present disclosure;
FIG. 4 is a fourth schematic view of the array substrate according to the embodiments of the present disclosure;
FIG. 5 is a fifth schematic view of the array substrate according to the embodiments of the present disclosure;
FIG 6 is a sixth schematic view of the array substrate according to the embodiments of the present disclosure;
FIG. 7 is a seventh schematic view of the array substrate according to the embodiments of the present disclosure;
FIG. 8 is an eighth schematic view of the array substrate according to the embodiments of the present disclosure;
FIG. 9 is a schematic view of a display device according to the embodiments of the present disclosure;
FIG. 10A-10F are first schematic views of a manufacturing method of the array substrate according to the embodiments of the present disclosure;
FIG. 11A-11E are second schematic views of the manufacturing method of the array substrate according to the embodiments of the present disclosure;
FIG. 12A-12E are third schematic views of the manufacturing method of the array substrate according to the embodiments of the present disclosure;
FIG. 13A-13D are fourth schematic views of the manufacturing method of the array substrate according to the embodiments of the present disclosure.

### DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment(s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "right," "left" and the like are only used to indicate relative position relationship, and when the position of the object which is described is changed, the relative position relationship may be changed accordingly.

In a manufacturing process of a display panel, leading wires in different layers or conductive layers in different layers are needed to be electrically connected with each other; for example, data lines or scan lines are electrically connected with a driving circuit or the like. For example, an insulating layer is between the leading wires in different layers or the conductive layers in different layers; in this case, for example, a via hole structure is formed in the insulating layer to electrically connect the leading wires in different layers or the conductive layers in different layers. The inventors of the present disclosure found in the study that after forming the via hole structure in the insulating layer and filling a conductive material to electrically connect the leading wires in different layers or the conductive layers in different layers or electrically connect the leading wire and the conductive layer which are located in different layers, loss of a portion of the leading wire or the conductive layer below the via hole structure may be caused due to factors such as process fluctuation or etching precision; at the same time, because of relatively poor denseness of the conductive material covering the via hole structure, a device is easily affected by water vapor in the environment especially if the device is placed in the environment for a long time, resulting in that phenomena such as corrosion of the leading wire or the conductive layer below the via hole structure affect a normal operation of the device.

At least one embodiment of the present disclosure provides an array substrate, the array substrate includes: a base substrate; a first conductive pattern on the base substrate; an insulating layer which is on a side of the first conductive pattern away from the base substrate and has a via hole structure; a second conductive pattern which is on a side of the insulating layer away from the base substrate and is electrically connected with the first conductive pattern at the via hole structure; and a protective pattern on a side of the first conductive pattern away from the base substrate. An orthographic projection of the protective pattern on the base substrate at least partially overlaps an orthographic projection of the via hole structure on the base substrate.

At least one embodiment of the present disclosure provides a display device including the above array substrate.

At least one embodiment of the present disclosure provides a manufacturing method of the array substrate, and the manufacturing method includes: forming a first conductive pattern on a base substrate; forming an insulating film on a side of the first conductive pattern away from the base substrate, and treating the insulating film to form an insulating layer and a via hole structure in the insulating layer; forming a second conductive pattern on a side of the insulating layer away from the base substrate, so' that the second conductive pattern is electrically connected with the first conductive pattern at the via hole structure; and forming a protective pattern on the side of the first conductive pattern away from the base substrate. In the manufacturing method, an orthographic projection of the protective pattern on the base substrate at least partially overlaps an orthographic projection of the via hole structure on the base substrate.

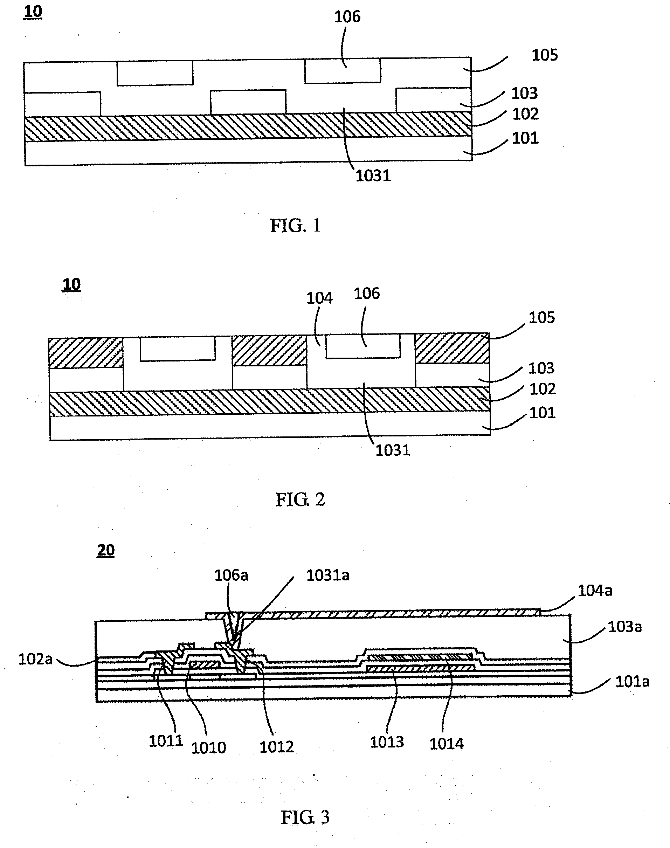

At least one embodiment of the present disclosure provides the array substrate. In one example of the present disclosure, as shown in FIG. 1, the array substrate includes: the base substrate 101, the first conductive pattern 102, the insulating layer 103, the second conductive pattern 105 and the protective pattern 106. The first conductive pattern 102 is disposed on the base substrate 101; the insulating layer 103 is disposed on the side of the first conductive pattern 102 away from the base substrate 101, and the via hole structure 1031 is in the insulating layer 103; the second conductive pattern 105 is disposed on the side of the insulating layer 103 away from the base substrate 101, and the second conductive pattern 105 is electrically connected with the first conductive pattern 102 at the via hole structure 1031; the protective pattern 106 is disposed on the side of the first conductive pattern 102 away from the base substrate 101, and the orthographic projection of the protective pattern 106 on the base substrate 101 at least partially overlaps the orthographic projection of the via hole structure 1031 on the base substrate 101.

For example, the protective pattern 106 located on an upper side of the via hole structure 1031 in the example shown in FIG. 1 functions as a protective layer, to protect the first conductive pattern 102 and to avoid undesirable phenomena such as corrosion generated in the first conductive pattern 102 and caused by water vapor entering the first conductive pattern 102 from the environment. For example, the second conductive pattern 105 is directly electrically connected with the first conductive pattern 102, which increases a contact area between the second conductive pattern 105 and the first conductive pattern 102, and ensures that the second conductive pattern 105 and the first conductive pattern 102 are well electrically connected with each other.

For example, in the example shown in FIG. 1, the protective pattern 106 is a photoresist pattern, or the protective pattern 106 is a protective pattern formed by using an inorganic material or other organic material. In a situation where the protective pattern 106 is the photoresist pattern, the photoresist pattern is formed, for example, by a photoresist used in forming the second conductive pattern 105 by a patterning process, so that the photoresist pattern functioning as the protective pattern and the second conductive pattern 105 are formed in one patterning process without individually forming the protective pattern, thereby saving material and simplifying the manufacturing process. In a situation where the protective pattern 106 is formed by using the inorganic material or the organic material, the inorganic material is, for example, silicon oxide, silicon nitride or silicon oxynitride or the like, the organic material is, for example, a resin material or the like, and the embodiments of the present disclosure are not limited thereto.

For example, as shown in FIG. 1, the orthographic projection of the protective pattern 106 on the base substrate 101 partially or completely overlap the orthographic projection of the via hole structure 1031 on the base substrate 101. For example, the orthographic projection of the protective pattern 106 on the base substrate 101 is located inside the orthographic projection of the via hole structure 1031 on the base substrate 101.

For example, as shown in FIG. 1, an upper surface of the protective pattern 106 is coplanar with an upper surface of the second conductive pattern 105, so that the upper surface of the protective pattern 106 and the upper surface of the second conductive pattern 105 form a flat surface.

For example, in another embodiment of the present disclosure, as shown in FIG. 2, the array substrate includes: the base substrate 101, the first conductive pattern 102, the insulating layer 103, a connection electrode 104, the second conductive pattern 105 and the protective pattern 106. The first conductive pattern 102 is disposed on the base substrate 101; the insulating layer 103 is disposed on the side of the first conductive pattern 102 away from the base substrate 101, and the via hole structure 1031 is in the insulating layer 103; the second conductive pattern 105 is disposed on the side of the insulating layer 103 away from the base substrate 101; the connection electrode 104 is disposed in the via hole structure 1031 of the insulating layer 103, so that the connection electrode 104 electrically connects the second conductive pattern 105 and the first conductive pattern 102; the protective pattern 106 is disposed on a side of the connection electrode 104 away from the base substrate 101, and the orthographic projection of the protective pattern 106 on the base substrate 101 at least partially overlaps the orthographic projection of the via hole structure 1031 on the base substrate 101. For example, in the example shown in FIG. 2, the protective pattern 106 located on the upper side of the via hole structure 1031 functions as the protective layer, to protect the connection electrode 104 and to avoid undesirable phenomena such as the corrosion generated in the first conductive pattern 102 below the via hole structure 1031 and caused by the water vapor entering the connection electrode 104 from the environment.

For example, in the example shown in FIG. 2, the protective pattern 106 is a photoresist pattern, or the protective pattern 106 is a protective pattern formed by using an inorganic material or other organic material. In a situation where the protective pattern 106 is the photoresist pattern, the photoresist pattern is formed, for example, by a photoresist used in forming the connection electrode 104 by a patterning process, so that the photoresist pattern functioning as the protective pattern and the connection electrode are formed in one patterning process without individually forming the protective pattern, thereby saving the material and simplifying the manufacturing process. In a situation where the protective pattern 106 is formed by using the inorganic material or the organic material, the inorganic material is, for example, silicon oxide, silicon nitride or silicon oxynitride or the like, the organic material is, for example, a resin material or the like, and the embodiments of the present disclosure are not limited thereto.

For example, the second conductive pattern 105 and the connection electrode 104 in FIG. 2 are integral with each other (that is, the second conductive pattern 105 and the connection electrode 104 in FIG. 2 are of a one-piece structure), in this case, the second conductive pattern 105 and the connection electrode 104 are formed by patterning the same film with the same patterning process to obtain the same structure as shown in FIG. 2. In this way, the connection between the second conductive pattern 105 and the connection electrode 104 is more consistent and stable, and the manufacturing process of the array substrate is also simplified.

For example, in at least one embodiment of the present disclosure, as shown in FIG. 2 and FIG 3, the array substrate includes a display region 20 and a peripheral region 10, and the first conductive pattern 102, the insulating layer 103, the second conductive pattern 105, the connection electrode 104, and the protective pattern 106 are disposed at least in the peripheral region 10. For example, the first conductive pattern 102, the insulating layer 103, the second conductive pattern 105, the connection electrode 104 and the protective pattern 106 are disposed only in the peripheral region 10, or disposed in both the display region 20 and the peripheral region 10. In some examples, the first conductive pattern 102, the insulating layer 103, the second conductive pattern 105, the connection electrode 104 and the protective pattern 106 are disposed only in the display region 20.

For example, FIG. 2 illustrates a case where the first conductive pattern 102, the insulating layer 103, the connection electrode 104, the second conductive pattern 105 and the protective pattern 106 are disposed in the peripheral region 10. Because the peripheral region 10 originally lacks a protective structure, the protective pattern 106 disposed on the upper side of the via hole structure 1031 functions as the protective layer to protect the connection electrode 104 and to avoid undesirable phenomena such as the corrosion generated in the first conductive pattern 102 below the via hole structure 1031 and caused by the water vapor entering the connection electrode 104 from the environment.

For example, as shown in FIG. 2, the orthographic projection of the protective pattern 106 on the base substrate 101 partially or completely overlaps the orthographic projection of the via hole structure 1031 on the base substrate 101. For example, the orthographic projection of the protective pattern 106 on the base substrate 101 is located inside the orthographic projection of the via hole structure 1031 on the base substrate 101.

For example, as shown in FIG. 2, the upper surface of the protective pattern 106 is coplanar with an upper surface of the connection electrode 104, so that the upper surface of the protective pattern 106 and the upper surface of the connection electrode 104 form a flat surface.

It should be noted that the upper surface of the protective pattern 106 is coplanar with the upper surface of the connection electrode 104, that is, the surface which is included by the protective pattern 106 and is away from the base substrate 101 and the surface which is included by the connection electrode 104 and is away from the base substrate 101 are substantially in a same horizontal plane, that is, a shortest distance between the base substrate 101 and the surface which is included by the protective pattern 106 and is away from the base substrate 101 is substantially same as a shortest distance between the base substrate 101 and the surface which is included by the connection electrode 104 and is away from the base substrate 101.

For example, as shown in FIG. 2, an orthographic projection of the connection electrode 104 on the base substrate 101 completely coincides with the orthographic projection of the via hole structure 1031 on the base substrate 101; in this case, the orthographic projection of the protective pattern 106 on the base substrate 101 is located inside the orthographic projection of the connection electrode 104 on the base substrate 101.

For example, as shown in FIG. 2, the second conductive patterns 105 are disposed on two sides of the via hole structure 1031 and are in direct contact with two side surfaces of the connection electrode 104.

For example, in the example shown in FIG. 2, the upper surface of the second conductive pattern 105, the upper surface of the connection electrode 104 and the upper surface of the protective pattern 106 are all coplanar. In this case, the upper surface of the second conductive pattern 105, the upper surface of the connection electrode 104 and the upper surface of the protective pattern 106 form a flat surface, and the flat surface is convenient for arrangement of other structures such as a driving circuit or the like in the case that the structures such as the driving circuit or the like are electrically connected with the first conductive pattern 102 through the second conductive pattern 105 and the connection electrode 104.

For example, in one example of the present disclosure, the first conductive pattern 102 is, for example, a leading wire electrically connected with a source electrode or a drain electrode or a gate electrode of a thin film transistor or the like in the display region, and the leading wire extends from the display region to the peripheral region, for example, thereby forming the first conductive pattern 102 located in the peripheral region.

For example, as shown in FIG. 3, the display region 20 includes the thin film transistor which is disposed, for example, on a base substrate 101a. For example, the thin film transistor includes structures such as the gate electrode 1010, the source electrode 1011 and the drain electrode 1012. For example, a case where a first leading wire 102a and the source electrode 1011 are disposed in a same layer and electrically connected with each other is shown in FIG. 3. For example; being disposed in the same layer means being formed by patterning a same film with a same patterning process. For example, the first leading wire 102a and the source electrode 1011 are integral with each other and are formed by using a same film. For example, the first leading wire 102a extends from the display region 20 to the peripheral region 10, thereby forming the first conductive pattern 102 of the peripheral region 10.

For example, in other examples, the first leading wire 102a and the gate electrode 101 (or the drain electrode 1012) are disposed in a same layer and electrically connected with each other. For example, the first leading wire 102a and the gate electrode 1010 (or the drain electrode 1012) are integral with each other and are formed by using a same film.

For example, the display region 20 further includes other structures such as a capacitor (for example, the capacitor includes a lower plate 1013 and an upper plate 1014) or the like. The embodiments of the present disclosure do not limit the specific structure of the display region 20.

For example, in an example of the present disclosure, the display region 20 further includes a driving electrode configured for driving a pixel unit in the display region to emit light; the driving electrode is, for example, a pixel electrode or a common electrode or the like. For example, the driving electrode and the connection electrode are disposed in a same layer.

For example, as shown in FIG. 3, the driving electrode located in the display region 20 is a pixel electrode 104a. For example, the pixel electrode 104a and the connection electrode 104 which is in the peripheral region 10 are disposed in the same layer; for example, the pixel electrode 104a and the connection electrode 104 which is in the peripheral region 10 are formed by patterning a same film with a same patterning process. For example, a material of the driving electrode and the connection electrode 104 is a transparent conductive material. For example, the transparent conductive material is indium tin oxide or the like.

For example, as shown in FIG. 3, the pixel electrode 104a is electrically connected with the drain electrode 1012 of the thin film transistor, so that the pixel electrode 104a obtains a driving signal transmitted by the thin film transistor and drives the pixel unit in the display region to emit light.

For example, in the example shown in FIG. 3, the drain electrode 1012 of the thin film transistor located in the display region is electrically connected with the pixel electrode 104a through a via hole structure 1031a in an insulating layer 103a, thereby forming a structure of first conductive pattern-insulating layer-second conductive pattern in the display region. For example, a protective pattern 106a is further disposed on the pixel electrode 104a, and the orthographic projection of the protective pattern 106a on the base substrate 101a at least partially overlaps the orthographic projection of the via hole structure 1031a in the insulating layer 103a on the base substrate 101a; for example, the orthographic projection of the protective pattern 106a completely overlaps the orthographic projection of the via hole structure 1031a. The protective pattern 106a is completely filled in the via hole structure 1031a in the insulating layer 103a. For example, the upper surface of the protective pattern 106a and the upper surface of the pixel electrode 104a are substantially in a same plane. In this structure, the protective pattern 106a on the upper side of the via hole structure 1031a in the insulating layer 103a functions as a protective layer to avoid undesirable phenomena such as the corrosion generated in the drain electrode 1012 below the via hole structure 1031a and caused by the water vapor from the environment entering the drain electrode 1012 through the via hole structure 1031a in the insulating layer 103a.

For example, the protective pattern 106a is formed by a photoresist used in forming the pixel electrode 104a by a patterning process, so that the protective pattern 106a functioning as the protective layer and the pixel electrode 104a are formed by one patterning process without individually forming the protective layer, which saves material and simplifies the manufacturing process.

For example, in at least one embodiment of the present disclosure, the peripheral region 10 further includes a flexible circuit board (chip on FPC (COF)) or an integrated circuit board (IC), and the second conductive pattern 105 is configured to electrically connect the flexible circuit board or the integrated circuit board.

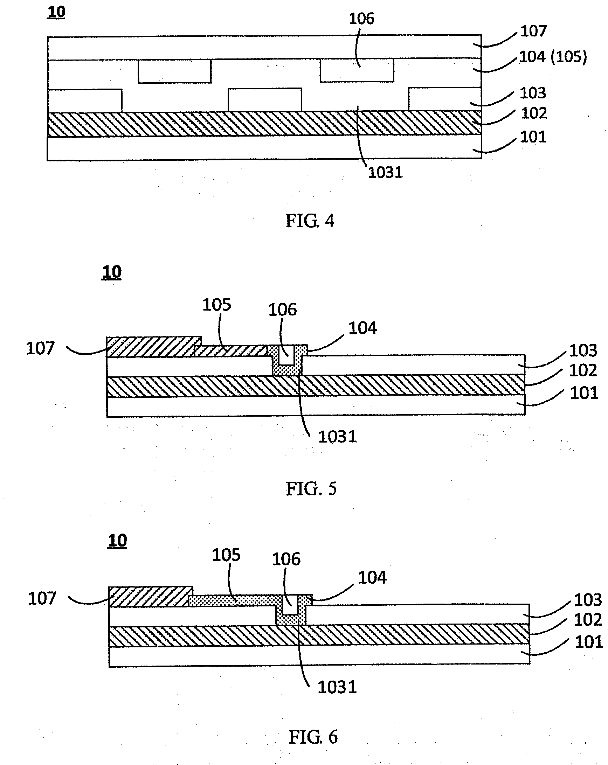

For example, in another example, as shown in FIG. 4, the integrated circuit board 107 is provided on the second conductive pattern 105, the integrated circuit board 107 is electrically connected with the second conductive pattern 105, and the connection electrode 104 in the via hole structure 1031 of the insulating layer 103 electrically connects the second conductive pattern 105 and the first conductive pattern 102, so that the integrated circuit board 107 provides an electrical signal, such as a data signal or a scan signal or the like, to the thin film transistor in the display region 20.

In the above-described example of the present disclosure, the base substrate 101/101a is, for example, a hard substrate such as a glass substrate or a quartz substrate, or a flexible substrate such as polyethylene terephthalate (PET). A material of the first conductive pattern 102 is, for example, a metal material which is, for example, an element metal such as aluminum, molybdenum or neodymium, or an alloy material such as an aluminum alloy, a molybdenum alloy or a neodymium alloy. The insulating layer 103/103a is, for example, an organic material such as a resin or an inorganic material such as silicon nitride or silicon oxide. The second conductive pattern 105 is, for example, a metal material which is, for example, an element metal such as aluminum, molybdenum or neodymium or an alloy material such as an aluminum alloy, a molybdenum alloy or a neodymium alloy, or is a transparent conductive material such as indium tin oxide or the like. A material of the photoresist pattern is, for example, a photoresist material such as polyimide (PI), polymethyl methacrylate (PMMA) or organic silicon. The embodiments of the present disclosure do not limit the specific materials of the respective functional layers.

At least one embodiment of the present disclosure further provides another array substrate. As shown in FIG. 5, the array substrate includes: the base substrate 101, the first conductive pattern 102, the insulating layer 103, the connection electrode 104, the second conductive pattern 105 and the protective pattern 106. The first conductive pattern 102 is disposed on the base substrate 101; the insulating layer 103 is disposed on the side of the first conductive pattern 102 away from the base substrate 101, and the via hole structure 1031 is in the insulating layer 103; the second conductive pattern 105 is disposed on the side of the insulating layer 103 away from the base substrate 101; the connection electrode 104 is disposed in the via hole structure 1031 of the insulating layer 103, two sides of the connection electrode 104 overlaps the insulating layer 103, the orthographic projection of the connection electrode 104 on the base substrate 101 is larger than the orthographic projection of the via hole structure 1031 on the base substrate 101, and the connection electrode 104 electrically connects the second conductive pattern 105 and the first conductive pattern 102; the protective pattern 106 is disposed on the side of the connection electrode 104 away from the base substrate 101, and the orthographic projection of the protective pattern 106 on the base substrate 101 at least partially overlaps the orthographic projection of the via hole structure 1031 on the base substrate 101.

For example, as shown in FIG. 5, the connection electrode 104 has a groove structure, and the protective pattern 106 is inside the groove structure of the connection electrode 104, and the upper surface of the protective pattern 106 and the upper surface of the connection electrode 104 are substantially coplanar with each other.

For example, as shown in FIG. 5, the upper surface of the second conductive pattern 105, the upper surface of the connection electrode 104 and the upper surface of the protective pattern 106 are substantially in the same plane, and the second conductive pattern 105 is formed on one side of the connection electrode 104.

In another example of the present disclosure, as shown in FIG. 6, for example, the second conductive pattern 105 and the connection electrode 104 are integral with each other (that is, the second conductive pattern 105 and the connection electrode 104 are of a one-piece structure), in this case, the second conductive pattern 105 and the connection electrode 104 are formed by patterning the same film with the same patterning process; both of the two sides of the connection electrode 104 overlaps the insulating layer 103, and the orthographic projection of the connection electrode 104 on the base substrate 101 is larger than the orthographic projection of the via hole structure 1031 on the base substrate 101.

For example, only one side of the connection electrode 104 overlaps the insulating layer 103, and the orthogonal projection of the connection electrode 104 on the base substrate 101 is larger than the orthographic projection of the via hole structure 1031 on the base substrate 101.

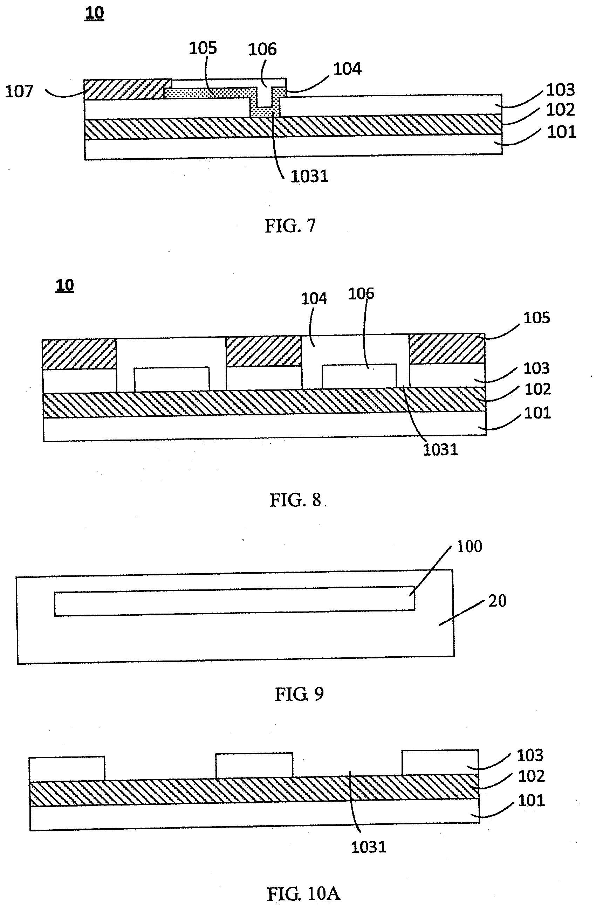

For example, in another example of the present disclosure, as shown in FIG. 7, for example, the protective pattern 106 is formed on both the second conductive pattern 105 and the connection electrode 104, thereby simultaneously protecting the second conductive pattern 105, the connection electrode 104, and the first conductive pattern 102 which is below the via hole structure 1031.

Similarly, for the array substrate shown in FIG. 7, for example, the protective pattern 106 is formed on both the second conductive pattern 105 and the connection electrode 104, so as to simultaneously protect the second conductive pattern 105, the connection electrode 104, and the first conductive pattern 102 which is below the via hole structure 1031.

Compared with the foregoing examples, relative positional relationships of some functional layers are changed in the examples of the array substrate shown in FIG. 5 to FIG. 7. For example, the integrated circuit board 107 is formed on one side of the peripheral region 10; and by a connection between the second conductive pattern 105 and the connection electrode 104 and a connection between the connection electrode 104 and the first conductive pattern 102, an electrical connection between the integrated circuit board 107 and the first conductive pattern 104 is realized. In the embodiments of the present disclosure, the forming materials, the connection relationships, and the like of the respective functional layers are the same as the above-described respective examples, and details are not described herein again.

It should be noted that, in the examples of the array substrate shown in FIG. 5 to FIG. 7, for example, the second conductive pattern 105 is provided on two sides of the via hole structure 1031.

In another example of the present disclosure, as shown in FIG. 8, the protective pattern 106 is provided, for example, in the via hole structure 1031 and provided between the connection electrode 104 and the first conductive pattern 102, as long as it is ensured that the first conductive pattern 102 and a part of the connection electrode 104 are electrically connected with each other. The orthographic projection of the connection electrode 104 on the base substrate 101 completely coincides with the orthographic projection of the via hole structure 1031 on the base substrate 101, and in this case, the orthographic projection of the protective pattern 106 on the base substrate 101 is located inside the orthographic projection of the connection electrode 104 on the base substrate 101, so that the protective pattern 106 disposed in the via hole structure 1031 functions as a protective layer, to protect the first conductive pattern 102, to reduce material loss of the first conductive pattern 102 caused by factors such as process fluctuation or etching precision in forming a subsequent film, and to avoid undesirable phenomena such as the corrosion generated in the first conductive pattern 102 below the via hole structure 1031 and caused by the water vapor entering the connection electrode 104 from the environment.

Likewise, the solution that the protective pattern 106 is provided in the via hole structure 1031 and provided between the connection electrode 104 and the first conductive pattern 102 is applicable to the example shown in FIG. 5, and details are not described herein again.

The embodiments of the present disclosure further provide a display panel. As shown in FIG. 9, the display panel 20 includes the array substrates 100 described in any one of the above embodiments. The display panel is, for example, a liquid crystal display panel, an organic light-emitting display panel, or a quantum dot light-emitting display panel, which is not limited thereto.

The embodiments of the present disclosure further provide a display device which includes the above display panel, and the display device may be any product or component having a display function, such as a mobile phone, a tablet computer, a television, a display, a notebook computer, a digital photo frame, a navigator, and the like.

The embodiments of the present disclosure further provide a manufacturing method of the array substrate, and the method includes: forming the first conductive pattern on the base substrate; forming an insulating film on the side of the first conductive pattern away from the base substrate, and treating the insulating film to form the insulating layer and the via hole structure in the insulating layer; forming the second conductive pattern on the side of the insulating layer away from the base substrate, so that the second conductive pattern is electrically connected with the first conductive pattern at the via hole structure; and forming the protective pattern on the side of the first conductive pattern away from the base substrate, so that an orthographic projection of the protective pattern on the base substrate at least partially overlaps an orthographic projection of the via hole structure on the base substrate.

For example, the protective pattern located on the upper side of the via hole structure functions as a protective layer to protect the first conductive pattern and to prevent undesirable phenomena such as the corrosion generated in the first conductive pattern and caused by the water vapor entering the first conductive pattern from the environment. The second conductive pattern is directly electrically connected with the first conductive pattern, which increases the contact area between the second conductive pattern and the first conductive pattern, and ensures a better electrical connection between the second conductive pattern and the first conductive pattern.

For example, in still another example of the present disclosure, the manufacturing method of the array substrate further includes forming the connection electrode, and the connection electrode is formed in the via hole structure to electrically connect the second conductive pattern with the first conductive pattern.

For example, the protective pattern located on the upper side of the via hole structure functions as a protective layer to protect the connection electrode and prevent undesirable phenomena such as the corrosion generated in the first conductive pattern below the via hole structure and caused by the water vapor entering the connection electrode from the environment.

For example, the second conductive pattern is in direct connection with the first conductive pattern; or the second conductive pattern is in connection with the first conductive pattern through the connection electrode, and the manufacturing process in which the connection electrode and the second conductive pattern are integrally formed is shown in FIG. 10A to FIG. 10F.

For example, as shown in FIG. 10A, firstly, the first conductive pattern 102 is formed on the base substrate 101. In the embodiments of the present disclosure, for example, the base substrate is a hard substrate such as a glass substrate or a quartz substrate, or is a flexible substrate such as polyethylene terephthalate (PET). The first conductive pattern 102 is formed by, for example, a metal material which is, for example, an element metal such as aluminum, molybdenum or neodymium or an alloy material such as an aluminum alloy, a molybdenum alloy or a neodymium alloy.

For example, a first conductive material film is firstly formed on the base substrate 101 by sputtering or evaporation, and then a patterning process including procedures such as exposure, development and etching is performed on the first conductive material film to form the first conductive pattern 102.

For example, after the first conductive pattern 102 is formed, for example, the insulating film is formed on the first conductive pattern 102 by deposition or the like, and then the via hole structure 1031 is formed in the insulating film by a patterning process to finally obtain the patterned insulating layer 103.

In the embodiments of the present disclosure, the insulating layer 103 is formed by, for example, an organic material such as a resin or an inorganic material such as silicon nitride or silicon oxide, which is not limited in the embodiments of the present disclosure.

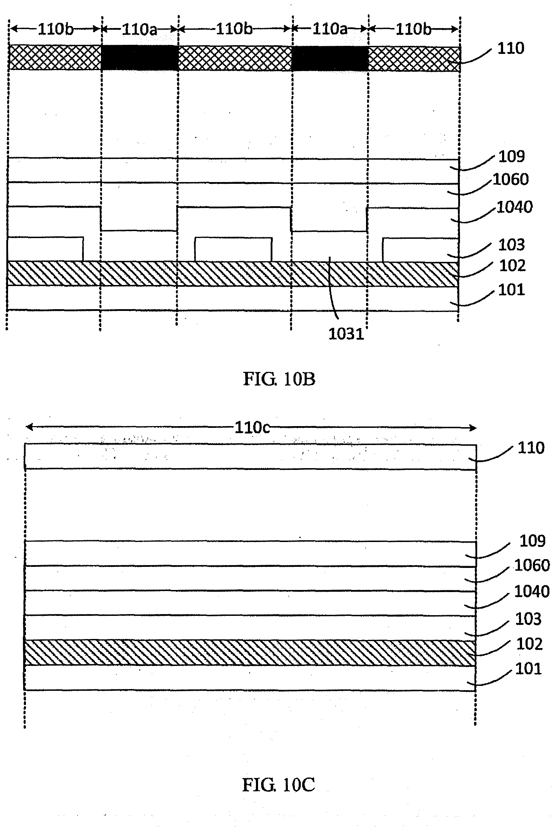

For example, as shown in FIG 10B, after the insulating layer 103 is formed, a conductive layer 1040, a protective layer 1060 and a first photoresist layer 109 are sequentially formed on the insulating layer 103. For example, the conductive layer 1040 adopts a metal material which is, for example, an element metal such as aluminum, molybdenum or neodymium, or an alloy material such as an aluminum alloy, a molybdenum alloy or a neodymium alloy; or, for example, the conductive layer 1040 adopts a transparent conductive material such as indium tin oxide or the like. The protective layer 1060 adopts, for example, an organic material such as a resin or an inorganic material such as silicon nitride or silicon oxide or the like. The first photoresist layer 109 adopts, for example, a photoresist material such as polyimide (PI), polymethyl methacrylate (PMMA) or organic silicon. The embodiments of the present disclosure do not limit the specific materials of the respective layers.

For example, the first photoresist layer 109 is exposed by using a two-tone mask 110 (for example, the two-tone mask 110a is a halftone mask or a gray tone mask) and is developed to form a first photoresist pattern. For example, the first photoresist pattern includes a first photoresist full-retention region, a first photoresist partial-retention region and a first photoresist removal region. For example, a region where the first photoresist full-retention region is located is a region where the protective pattern is to be formed, a region where the first photoresist removal region is located is a region where the protective pattern and the second conductive pattern (or, the protective pattern, the connection electrode and the second conductive pattern) are not formed, and a region where the first photoresist partial-retention region is located is a region except the first photoresist full-retention region and the first photoresist removal region.

For example, as shown in FIG. 10B and FIG. 10C, the first photoresist full-retention region corresponds to an opaque region 110a of the two-tone mask 110, the first photoresist partial-retention region corresponds to a semi-transparent region 110b of the two-tone mask 110, and the first photoresist removal region corresponds to a completely light-transmitting region 110c of the two-tone mask 110. For example, as shown in FIG. 10C, the first photoresist removal region corresponds to, for example, a region where the second conductive pattern and the via hole structure in the insulating layer 103 are not formed.

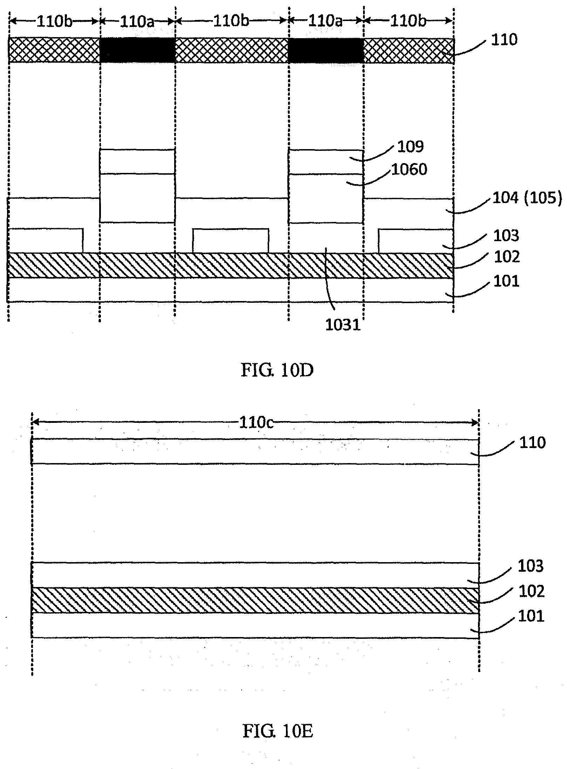

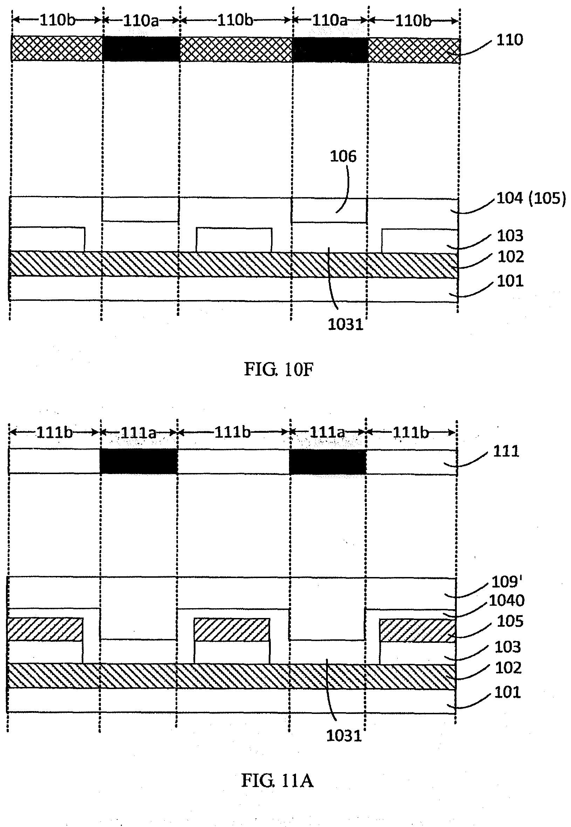

In the embodiments of the present disclosure, as shown in FIG. 10D and FIG. 10E, the photoresist material in the photoresist removal region is firstly removed; then the protective layer and the conductive layer which are in the photoresist removal region are removed by, for example, an etching method, to form the second conductive pattern 105 (or, the second conductive pattern 105 and the connection electrode 104 electrically connected with the second conductive pattern 105, that is, the second conductive pattern 105 and the connection electrode 104 electrically connected with the second conductive pattern 105 are integrally formed by a same film); then, the first photoresist pattern is ashed to retain a portion of the first photoresist layer only in the first photoresist full-retention region; for example, the protective layer outside the first photoresist full-retention region is removed by etching to form the protective pattern; finally, the photoresist in the first photoresist full-retention region is removed by, for example, a lift-off method. For example, as shown in FIG. 10F, after the photoresist in the first photoresist full-retention region is lifted off, the protective pattern is thinned by a process such as etching or the like, so that the upper surface of the protective pattern 106 and the upper surface of the second conductive pattern 105 (or, the upper surface of the protective pattern 106, the upper surface of the second conductive pattern 105 and the upper surface of the connection electrode 104) are coplanar with each other.

As shown in FIG. 10B to FIG. 10F, for example, one mask is used to pattern the conductive layer 1040 and the protective layer 1060 to form the second conductive pattern 105 (or, the second conductive pattern 105 and the connection electrode 104) and the protective pattern 106, which simplifies the manufacturing process.

In the embodiments of the present disclosure, the second conductive pattern 105 and the connection electrode 104 are formed separately, for example. For example, after the second conductive pattern 105 is formed by a patterning process, the connection electrode 104 electrically connected with the second conductive pattern 105 is formed. For example, in the embodiments of the present disclosure, the protective pattern 106 is formed separately, that is, after the second conductive pattern 105 and the connection electrode 104 are formed, the protective pattern 106 is formed by a patterning process using a single-tone mask.

For example, in one example of the present disclosure, the protective pattern 106 is formed of a photoresist.

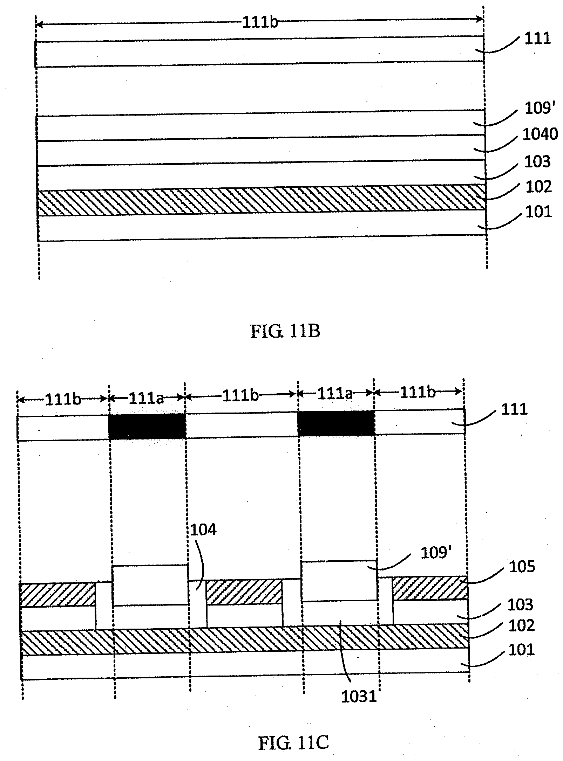

For example, in a case where the protective pattern 106 is formed of the photoresist, for example, the method shown in FIG. 11A to FIG. 11E is employed to manufacture the array substrate. For example, as shown in FIG. 11A and FIG. 11B, after the insulating layer 103 is formed, the second conductive pattern 105 is formed on the insulating layer 103 by a patterning process. For example, a second conductive material layer is formed on the insulating layer 103 by sputtering or evaporation, and then a patterning process is performed on the second conductive material layer to form the patterned second conductive pattern 105. The second conductive pattern 105 adopts, for example, a metal material which is, for example, an element metal such as aluminum, molybdenum or neodymium or an alloy material such as an aluminum alloy, a molybdenum alloy or a neodymium alloy, or a transparent conductive material such as indium tin oxide or the like.

For example, after the second conductive pattern 105 is formed, the conductive layer 1040 and a second photoresist layer 109' are sequentially formed. For example, the second photoresist layer 109' is exposed by using a single-tone mask 111 and is developed to form a second photoresist pattern. For example, the second photoresist pattern includes a second photoresist retention region and a second photoresist removal region. For example, the second photoresist retention region corresponds to an opaque region 111a of the single-tone mask 111, that is, the second photoresist retention region corresponds to a region where the protective pattern 106 is to be formed; the second photoresist removal region corresponds to a transparent region 111b of the single-tone mask 111, that is, the second photoresist removal region corresponds to a region outside a region where the protective pattern 106 is to be formed, as shown in FIG. 11A and FIG. 11B.

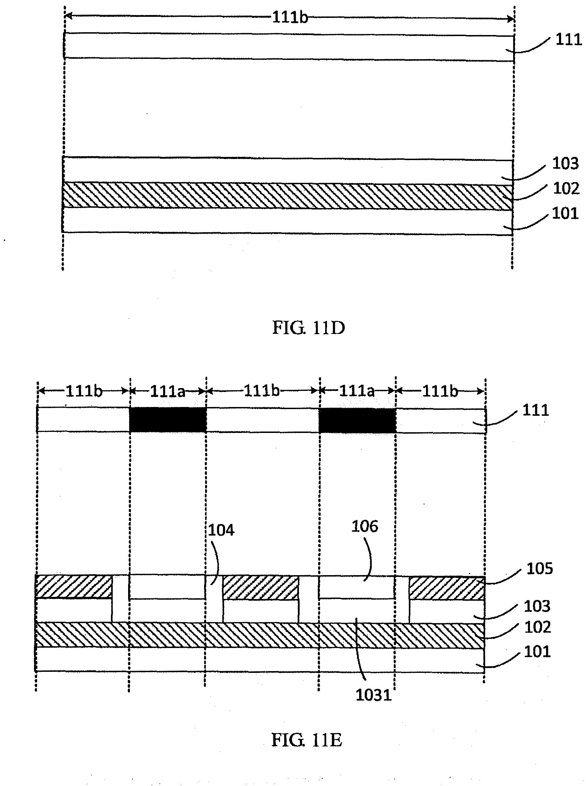

For example, as shown in FIG 11C and FIG 11D, the conductive layer 1040 is patterned by using the second photoresist pattern to form the connection electrode 104. As shown in FIG. 11E, for example, an ashing process is performed on the second photoresist pattern to form the protective pattern 106, so that a width of the second photoresist pattern is narrowed and a thickness of the second photoresist pattern is reduced. In this case, the upper surface of the protective pattern 106 is coplanar with both the upper surface of the second conductive pattern 105 and the upper surface of the connection electrode 104. Or, for example, the second photoresist pattern is not thinned but is directly used as the protective pattern.

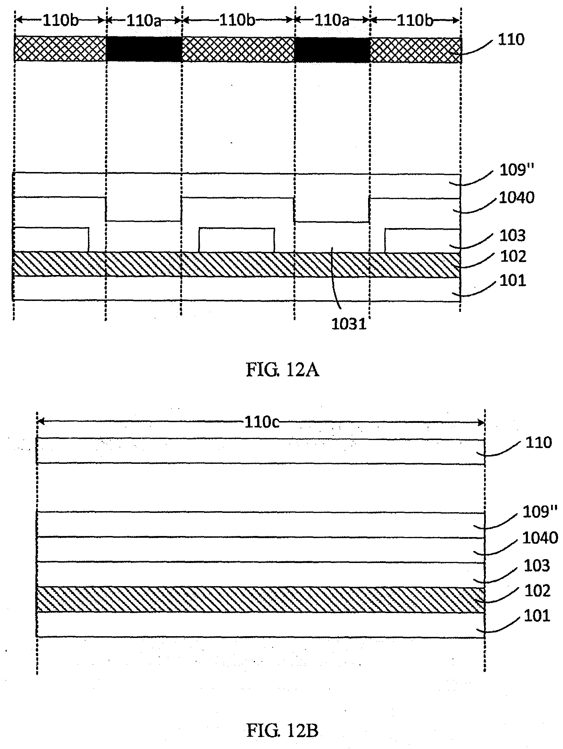

For example, in the case where the protective pattern 106 is formed of the photoresist, for example, the array substrate is manufactured by the method shown in FIG. 12A to FIG. 12E, and the second conductive pattern 105 and the connection electrode 104 are integrally formed, for example, by a same film.

For example, as shown in FIG 12A and FIG 12B, after the via hole structure 1031 in the insulating layer 103 is formed, the conductive layer 1040 and a third photoresist layer 109" are sequentially formed on the insulating layer 103. The third photoresist layer 109" is exposed by using a two-tone mask 110 and is developed to form a third photoresist pattern. For example, the third photoresist pattern includes a third photoresist full-retention region, a third photoresist partial-retention region and a third photoresist removal region. For example, a region where the third photoresist full-retention region is located is a region where the protective pattern is to be formed, a region where the third photoresist removal region is located is a region where the protective pattern, the connection electrode and the second conductive pattern are not formed, and a region where the third photoresist partial-retention region is located is a region except the third photoresist full-retention region and the third photoresist removal region.

For example, the third photoresist full-retention region corresponds to an opaque region 110a of the two-tone mask 110, the third photoresist partial-retention region corresponds to a semi-transparent region 110b of the two-tone mask 110, and the third photoresist removal region corresponds to a completely light-transmitting region 110c of the two-tone mask 110.

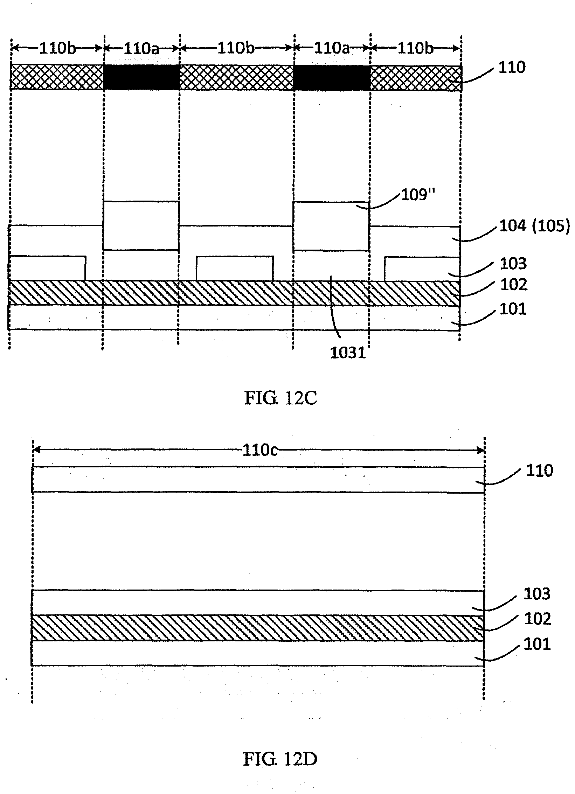

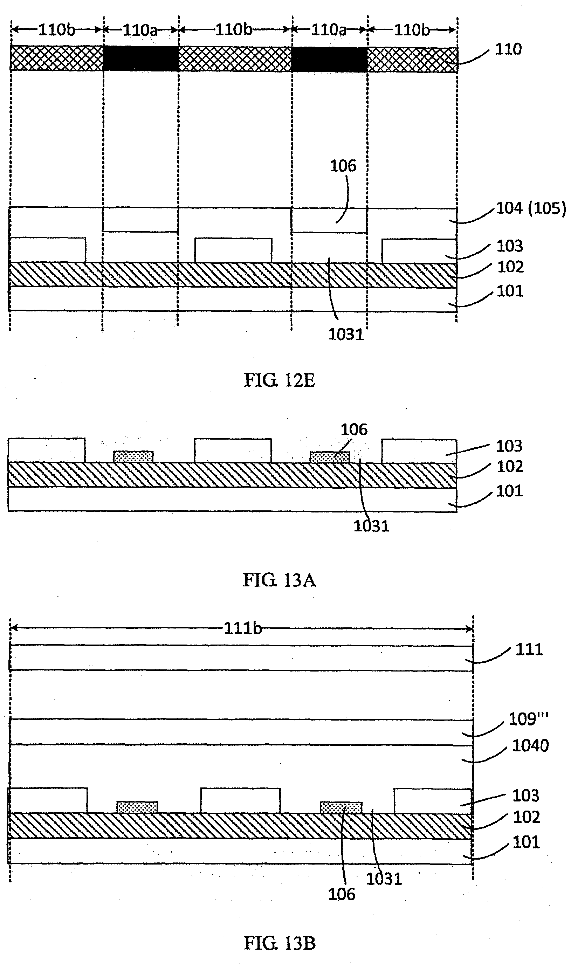

For example, as shown in FIG 12C and FIG. 12D, the photoresist material in the third photoresist removal region is firstly removed, and then the conductive layer in the photoresist removal region is removed by, for example, an etching method to form the second conductive pattern 105 and the connection electrode 104 electrically connected with the second conductive pattern 105 (i.e., the second conductive pattern 105 and the connection electrode 104 electrically connected with the second conductive pattern 105 are integrally formed by the same film). Then, the third photoresist pattern is treated, for example, firstly, the photoresist pattern in the third photoresist partial-retention region is removed, and then the photoresist pattern in the third photoresist full-retention region is partially removed to finally form the protective pattern 106 shown in FIG. 12E. For example, in other examples, for example, the photoresist pattern in the third photoresist partial-retention region and the third photoresist full-retention region is removed at the same time by ashing, and finally the protective pattern 106 as shown in FIG. 12E is formed.

In the method shown in FIG. 11A to FIG. 11E and the method shown in FIG. 12A to FIG. 12E, the protective pattern 106 is formed by using the photoresist used in the patterning process for forming the connection electrode, so that the protective pattern 106 serving as the protective layer and the connection electrode 104 are formed in one patterning process without individually forming the protective layer, saving material and simplifying the manufacturing process.

For example, in at least one embodiment of the present disclosure, the array substrate includes the display region 20 and the peripheral region 10; for example, the first conductive pattern 102, the insulating layer 103, the second conductive pattern 105, the connection electrode 104 and the protective pattern 106 are formed at least in the peripheral region 10. For example, the first conductive pattern 102, the insulating layer 103, the second conductive pattern 105, the connection electrode 104 and the protective pattern 106 are formed only in the peripheral region 10, or are formed in both the display region 20 and the peripheral region 10. In some examples, the first conductive pattern 102, the insulating layer 103, the second conductive pattern 105, the connection electrode 104 and the protective pattern 106 are formed only in the display region.

For example, in a situation where the second conductive pattern is in direct connection with the first conductive pattern (or, the second conductive pattern is in connection with the first conductive pattern through the connection electrode, and the connection electrode and the second conductive pattern are integral with each other), the manufacturing process in which the protective pattern is disposed in the via hole structure and on a side of the second conductive pattern close to the first conductive pattern (or, the protective pattern is disposed in the via hole structure and on a side of the connection electrode close to the first conductive pattern) is as shown in FIG. 13A to FIG. 13D.

For example, as shown in FIG. 13A, after the insulating layer 103 is formed, the protective pattern 106 is formed on the insulating layer 103. For example, the formation process of the protective pattern is a single-tone mask process, which is not described herein. For example, the protective pattern 106 adopts an organic material such as a resin or an inorganic material such as silicon nitride or silicon oxide.

For example, as shown in FIG. 13B, the conductive layer 1040 and a fourth photoresist layer 109'" are formed on the insulating layer 103 and the protective pattern 106. The conductive layer 1040 adopts, for example, a metal material which is, for example, an element metal such as aluminum, molybdenum or neodymium, or an alloy material such as an aluminum alloy, a molybdenum alloy or a neodymium alloy. For example, the conductive layer 1040 adopts a transparent conductive material such as indium tin oxide or the like. The fourth photoresist layer 109'" adopts, for example, a photoresist material such as polyimide (PI), polymethyl methacrylate (PMMA) or organic silicon. The embodiments of the present disclosure do not limit the specific materials of the respective layers.

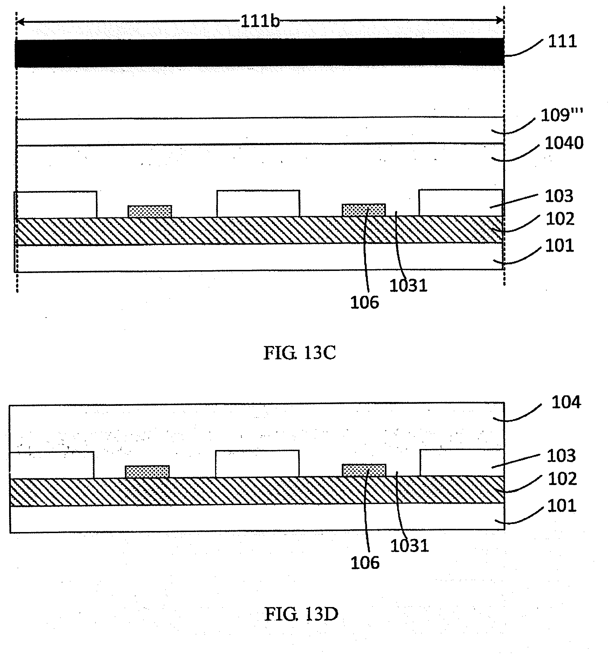

For example, as shown in FIG. 13C, the fourth photoresist layer 109'" is exposed by using a single-tone mask and is developed to form a fourth photoresist pattern. For example, the fourth photoresist pattern includes a fourth photoresist retention region and a fourth photoresist removal region. For example, a region where the fourth photoresist retention region is located is a region where the second conductive pattern (or, the connection electrode and the second conductive pattern) is to be formed, and the fourth photoresist removal region is a region where the second conductive pattern (or, the connection electrode and the second conductive pattern) is not formed.

For example, as shown in FIG. 13D, the conductive layer of the photoresist removal region is removed by, for example, an etching method to form the second conductive pattern 105 (or, the second conductive pattern 105 and the connection electrode 104 electrically connected with the second conductive pattern 105, that is, the second conductive pattern 105 and the connection electrode 104 electrically connected with the second conductive pattern 105 are integrally formed by the same film).

For example, the protective pattern 106 is formed in the via hole structure 1031 and formed between the second conductive pattern 105 (or the connection electrode 104) and the first conductive pattern 102, as long as it is ensured that the first conductive pattern 102 and a part of the second conductive pattern 105 (or the connection electrode 104) are electrically connected with each other. The orthographic projection of the protective pattern 106 on the base substrate 101 is located inside the orthographic projection of the second conductive pattern 105 (or the connection electrode 104) on the base substrate 101, so that the protective pattern 106 disposed in the via hole structure 1031 functions as a protective layer, to protect the first conductive pattern 102, to reduce the material loss of the first conductive pattern 102 caused by factors such as process fluctuation or etching precision in forming a subsequent film, and to avoid undesirable phenomena such as the corrosion generated in the first conductive pattern 102 below the via hole structure 1031 and caused by the water vapor entering the second conductive pattern 105 from the environment.

In at least one embodiment of the present disclosure, the first conductive pattern 102 is, for example, a leading wire electrically connected with the source electrode, the drain electrode or the gate electrode of the thin film transistor in the display region 20 of the array substrate. For example, the source electrode, the drain electrode or the gate electrode or the like located in the display region 20 and the first conductive pattern 102 are formed in a same patterning process.

For example, the manufacturing method of the array substrate further includes forming the thin film transistor in the display region 20, so that the thin film transistor includes structures such as the gate electrode, the source electrode and the drain electrode; for example, the first conductive pattern 102 and the gate electrode or the source electrode or the drain electrode are integrally formed by the same film.

In at least one embodiment of the present disclosure, the peripheral region 10 further includes, for example, a flexible circuit board or an integrated circuit board, and the second conductive pattern 105 is formed to electrically connect the flexible circuit board or the integrated circuit board, for example. In at least one embodiment of the present disclosure, the connection electrode 104 disposed in the via hole structure 1031 of the insulating layer 103 electrically connects the second conductive pattern 105 and the first conductive pattern 102, so that the integrated circuit board provides the thin film transistor in the display region with an electrical signal, such as a data signal or a scan signal.

In at least one embodiment of the present disclosure, the manufacturing method of the array substrate is, for example, further includes forming the driving electrode configured for driving the pixel unit in the display region to emit light in the display region 20. For example, the driving electrode and the connection electrode 104 are formed by patterning a same film with a same patterning process. For example, the driving electrode is the pixel electrode or the common electrode configured for driving the pixel unit in the display region to emit light. For example, the material of the driving electrode and the connection electrode 104 is a transparent conductive material, for example, indium tin oxide or the like.

Referring to FIG. 3, in the example shown in FIG. 3, the driving electrode is the pixel electrode 104a configured for driving the pixel unit in the display region to emit light, and in this case, the drain electrode 1012 of the thin film transistor located in the display region is electrically connected with the pixel electrode 104a through the via hole structure 1031a in the insulating layer 103a, thereby forming the structure of first conductive pattern-insulating layer-second conductive pattern in the display region. For example, the protective pattern 106a is further disposed on the pixel electrode 104a, and the orthographic projection of the protective pattern 106a on the base substrate 101a at least partially overlaps the orthographic projection of the via hole structure 1031a in the insulating layer 103a on the base substrate 101a; for example, the orthographic projection of the protective pattern 106a completely overlaps the orthographic projection of the via hole structure 1031a. In this structure, the protective pattern 106a on the upper side of the via hole structure functions as a protective layer to avoid undesirable phenomena such as the corrosion generated in the drain electrode 1012 below the via hole structure 1031a and caused by the water vapor entering the pixel electrode 104a from the environment.

For example, the protective pattern 106a is formed by a photoresist used in forming the pixel electrode 104a by a patterning process, so that the protective pattern 106a functioning as the protective layer and the pixel electrode 104a are formed in one patterning process without individually forming the protective layer, which saves material and simplifies the manufacturing process.

There are also the following points to be explained:
(1) The drawings of the embodiments of the present disclosure only relate to the structures mentioned in the embodiments of the present disclosure, and other structures can be referred to the general design.
(2) For the sake of clarity, in the drawings for describing the embodiments of the present disclosure, the thicknesses of layers or regions are enlarged or reduced, that is, the drawings are not drawn to actual scales. It will be understood that when an element such as a layer, a film, a region or a substrate is referred to as being "on" or "below" another element, the element may be "directly" "on" or "below" the another element or there may be an intermediate element between the element and the another element.
(3) In the case of no conflict, the embodiments of the present disclosure and the features in the embodiments may be combined with each other to obtain a new embodiment.

What are described above are only the specific embodiments of the present disclosure, but the protection scope of the present disclosure is not limited thereto, any person skilled in the art can easily think of changes or substitutions within the technical scope of the disclosure, and these changes or substitutions should be within the protection scope of the present disclosure. Therefore, the protection scope of the disclosure should be determined by the scope of the claims.

## Claims

1. An array substrate, comprising:
a base substrate;
a first conductive pattern on the base substrate;
an insulating layer on a side of the first conductive pattern away from the base substrate, wherein a via hole structure is in the insulating layer;
a second conductive pattern on a side of the insulating layer away from the base substrate, wherein the second conductive pattern is electrically connected with the first conductive pattern at the via hole structure;
a protective pattern on the side of the first conductive pattern away from the base substrate;
wherein an orthographic projection of the protective pattern on the base substrate at least partially overlaps an orthographic projection of the via hole structure on the base substrate.

2. The array substrate according to claim 1, wherein the protective pattern is a photoresist pattern.

3. The array substrate according to claim 1 or 2, wherein an upper surface of the second conductive pattern and an upper surface of the protective pattern are coplanar with each other.

4. The array substrate according to any one of claims 1 to 3, further comprising a connection electrode, wherein the connection electrode is in the via hole structure of the insulating layer and is electrically connected with the second conductive pattern and the first conductive pattern.

5. The array substrate according to claim 4, wherein the protective pattern is between the connection electrode and the first conductive pattern.

6. The array substrate according to claim 4, wherein an upper surface of the protective pattern and an upper surface of the connection electrode are coplanar with each other.

7. The array substrate according to claim. 6, wherein an upper surface of the second conductive pattern, the upper surface of the connection electrode and the upper surface of the protective pattern are coplanar with each other.

8. The array substrate according to any one of claims 4 to 7, wherein the second conductive pattern and the connection electrode are integral with each other.

9. The array substrate according to any one of claims 4-7, comprising a display region and a peripheral region, wherein the first conductive pattern, the insulating layer, the second conductive pattern, the connection electrode and the protective pattern are at least in the peripheral region.

10. The array substrate according to claim 9, wherein
the peripheral region further comprises a flexible circuit board or an integrated circuit board;
the second conductive pattern is electrically connected with the flexible circuit board or the integrated circuit board.

11. The array substrate according to claim 9, wherein
the display region comprises a driving electrode configured for driving a pixel unit in the display region to emit light;
the driving electrode and the connection electrode are in a same layer.

12. A manufacturing method of an array substrate, comprising:
providing a base substrate;
forming a first conductive pattern on the base substrate;
forming an insulating film on a side of the first conductive pattern away from the base substrate, and treating the insulating film to form an insulating layer and a via hole structure in the insulating layer;
forming a second conductive pattern on a side of the insulating layer away from the base substrate, wherein the second conductive pattern is electrically connected with the first conductive pattern at the via hole structure; and
forming a protective pattern on the side of the first conductive pattern away from the base substrate;
wherein an orthographic projection of the protective pattern on the base substrate at least partially overlaps an orthographic projection of the via hole structure on the base substrate.

13. The manufacturing method of the array substrate according to claim 12, wherein after the insulating film is treated to form the insulating layer and the via hole structure in the insulating layer, a conductive layer, a protective layer and a first photoresist layer are sequentially formed on the insulating layer;
the first photoresist layer is exposed by using a two-tone mask and is developed to form a first photoresist pattern, the first photoresist pattern comprises a first photoresist full-retention region, a first photoresist partial-retention region and a first photoresist removal region, a region where the first photoresist full-retention region is located is a region where the protective pattern is to be formed, a region where the first photoresist removal region is located is a region where the protective pattern and the second conductive pattern are not formed, and a region where the first photoresist partial-retention region is located is a region except the first photoresist full-retention region and the first photoresist removal region;
the protective layer and the conductive layer which are in the first photoresist removal region are removed to form the second conductive pattern;
the first photoresist pattern is ashed to retain the first photoresist layer only in the first photoresist full-retention region;
the protective layer outside the first photoresist full-retention region is removed to form the protective pattern; and
the first photoresist layer in the first photoresist full-retention region is removed.

14. The manufacturing method of the array substrate according to claim 12, further comprising forming a connection electrode, wherein the connection electrode is formed in the via hole structure to electrically connect the second conductive pattern and the first conductive pattern.

15. The manufacturing method of the array substrate according to claim 14, wherein after the insulating film is treated to form the insulating layer and the via hole structure in the insulating layer, a conductive layer, a protective layer and a first photoresist layer are sequentially formed on the insulating layer;
the first photoresist layer is exposed by using a two-tone mask and is developed to form a first photoresist pattern, the first photoresist pattern comprises a first photoresist full-retention region, a first photoresist partial-retention region and a first photoresist removal region, a region where the first photoresist full-retention region is located is a region where the protective pattern is to be formed, a region where the first photoresist removal region is located is a region where the protective pattern, the connection electrode and the second conductive pattern are not formed, and a region where the first photoresist partial-retention region is located is a region except the first photoresist full-retention region and the first photoresist removal region;
the protective layer and the conductive layer which are in the first photoresist removal region are removed to form the second conductive pattern and the connection electrode electrically connected with the second conductive pattern;
the first photoresist pattern is ashed to retain the first photoresist layer only in the first photoresist full-retention region;
the protective layer outside the first photoresist full-retention region is removed to form the protective pattern; and
the first photoresist layer in the first photoresist full-retention region is removed.

16. The manufacturing method of the array substrate according to claim 14, wherein the protective pattern is formed of a photoresist.

17. The manufacturing method of the array substrate according to claim 16, wherein
after the second conductive pattern is formed on the side of the insulating layer away from the base substrate, a conductive layer and a second photoresist layer are sequentially formed on the base substrate;
the second photoresist layer is exposed by using a single-tone mask and is developed to form a second photoresist pattern, and the conductive layer is patterned by using the second photoresist pattern to form the connection electrode; and
the second photoresist pattern is ashed to form the protective pattern.

18. The manufacturing method of the array substrate according to claim 16, wherein after the insulating film is treated to form the insulating layer and the via hole structure in the insulating layer, a conductive layer and a third photoresist layer are sequentially formed on the base substrate;
the third photoresist layer is exposed by using a two-tone mask and is developed to form a third photoresist pattern, the third photoresist pattern comprises a third photoresist full-retention region, a third photoresist partial-retention region and a third photoresist removal region, a region where the third photoresist full-retention region is located is a region where the protective pattern is to be formed, a region where the third photoresist removal region is located is a region where the protective pattern, the connection electrode and the second conductive pattern are not formed, and a region where the third photoresist partial-retention region is located is a region except the third photoresist full-retention region and the third photoresist removal region;
the conductive layer in the third photoresist removal region is removed to form the second conductive pattern and the connection electrode electrically connected with the second conductive pattern; and
the third photoresist pattern is ashed to retain the third photoresist layer only in the third photoresist full-retention region to form the protective pattern.

19. The manufacturing method of the array substrate according to claim 12, wherein after the insulating film is treated to form the insulating layer and the via hole structure in the insulating layer, the protective pattern is formed in the via hole structure; and a conductive layer and a fourth photoresist layer are formed on a side of the protective pattern away from the base substrate;
the fourth photoresist layer is exposed by using a single-tone mask and is developed to form a fourth photoresist pattern, and the conductive layer is patterned by using the fourth photoresist pattern to form the second conductive pattern.

20. A display device, comprising the array substrate according to any one of claims 1-11.
